# EUROPÄISCHE PATENTSCHRIFT

(11) **EP 3 130 935 B1**
(45) Veröffentlichungstag und Bekanntmachung des Hinweises auf die Patenterteilung: **13.06.2018**
(21) Anmeldenummer: 16181078.3
(22) Anmeldetag: 25.07.2016
(51) Int. Cl.: G01R 33/00

(54) **STABFÖRMIGER MAGNETFELDSENSOR**
ROD-SHAPED MAGNETIC FIELD SENSOR
CAPTEUR DE CHAMP MAGNETIQUE EN FORME DE TIGE

(30) Priorität: 11.08.2015 DE 102015215329
(43) Veröffentlichungstag der Anmeldung: 15.02.2017
(73) Patentinhaber: Continental Automotive GmbH, 30165 Hannover (DE)
(72) Erfinder: Wahler, Torsten, 78073 Bad Dürrheim (DE); Fricker, Jochen, 78176 Blumberg (DE)

(56) Entgegenhaltungen:
- EP-A1- 1 128 172
- WO-A1-2015/140089
- DE-A1- 10 232 315
- DE-B3-102014 205 308

## Beschreibung

Die Erfindung bezieht sich auf einen stabförmigen Magnetfeldsensor mit einem ein Außengewinde und einen Axialdichtbund des Magnetfeldsensors aufweisenden Außengehäuse, wobei das Außengehäuse eine das Außengewinde und den Axialdichtbund aufweisende Gewindehülse aufweist.

Ein Magnetfeldsensor der vorgenannten Art ist zum Beispiel als sogenannter Geschwindigkeitsgeber für einen Fahrtenschreiber in einem Kraftfahrzeug, insbesondere Nutzfahrzeug, bekannt. Der Magnetfeldsensor wird in ein Getriebegehäuse eines Fahrzeuggetriebes des Kraftfahrzeugs an einer Einschraubstelle des Getriebegehäuses eingeschraubt. Die Einschraubstelle ist in einer Außenwandung des Getriebegehäuses angeordnet und umfasst beispielsweise eine Gewindebohrung, in welche das Außengewinde des Außengehäuses des Magnetfeldsensors eingeschraubt wird. Beispiele von solchen Sensoren sind in WO2015/140089, DE102014 205308, DE10232315 und EP1128172 beschrieben.
Der Magnetfeldsensor erfasst eine Bewegung eines Getriebezahnrades des Fahrzeuggetriebes . Für eine präzise Funktionsweise des Magnetfeldsensors ist eine exakte Positionierung eines Sensorkopfs des Magnetfeldsensors zu dem Getriebezahnrad erforderlich. Ferner erfordert eine dauerhaft zuverlässige Funktionsweise des Magnetfeldsensors einen Schutz insbesondere der elektronischen und elektrischen Bauelemente vor aggressiven Umgebungseinflüssen, wie hohen Temperaturen und Schmierstoffen, in dem Getriebegehäuse. Diesem Schutz dient das Außengehäuse.

Der Axialdichtbund ist ein starrer Anschlag des Magnetfeldsensors. Um einen Verlust von Schmierstoffen, insbesondere Getriebeöl, aus dem Getriebegehäuse zu vermeiden, ist es bekannt, an der Einschraubstelle zwischen der Außenwandung des Getriebegehäuses und dem Magnetfeldsensor eine abdichtende Klebemasse vorzusehen. Das Vorsehen der Klebemasse bedeutet neben dem in Form der Klebemasse erforderlichen zusätzlichen Fertigungsmaterial zudem einen weiteren Verfahrensschritt bei dem Zusammenbau von Magnetfeldsensor und Getriebegehäuse. Aufgabe der Erfindung ist es, hier Abhilfe zu schaffen und einen Magnetfeldsensor der eingangs genannten Art zu liefern, der einen einfachen Aufbau bei gleichzeitig ermöglichter guter Abdichtung einer Einschraubstelle aufweist.

Diese Aufgabe wird erfindungsgemäß dadurch gelöst, dass die Gewindehülse ein radial auskragendes, in Axialrichtung elastisch verformbares Axialdichtelement aufweist, wobei das Axialdichtelement ein einziges Bauteil bildend mit der Gewindehülse verbunden ist und an seiner in Axialrichtung dem Außengewinde der Gewindehülse zugewandten Außenseite den Axialdichtbund bildet.

Der erfindungsgemäße Magnetfeldsensor ist durch die Merkmalskombination nach Anspruch 1 definiert und ist ein Magnetfeldsensor zum Einschrauben in eine Außenwandung eines Gehäuses, insbesondere eines Getriebegehäuses. Vorzugsweise ist der Magnetfeldsensor ein Magnetfeldsensor für ein Kraftfahrzeug, der in eine Außenwandung eines Getriebegehäuses des Kraftfahrzeugs eingeschraubt wird.

Bei einem Einschrauben des Magnetfeldsensors in die Außenwandung des Getriebegehäuses legt sich der Axialdichtbund des Magnetfeldsensors von außen an die Außenwandung des Getriebegehäuses abdichtend an. Der Axialdichtbund bildet beim Einschrauben des Magnetfeldsensors einen Anschlag, und nach Erreichen des Anschlags wird das Axialdichtelement gegen die Einschraubkraft elastisch verformt, wodurch sich der Axialdichtbund abdichtend an die Außenwandung anlegt.

Von besonderem Vorteil ist bei der Erfindung, dass die Gewindehülse ein Axialdichtelement aufweist, welches mit der Gewindehülse ein einziges Bauteil bildet. Dadurch ist das Axialdichtelement unverlierbar mit der Gewindehülse und damit auch dem Magnetfeldsensor verbunden. Ein zusätzlicher Montageschritt eines Hinzufügens eines Dichtelements vor oder bei einem Einschrauben des Magnetfeldsensors in beispielsweise ein Getriebegehäuse an einer Einschraubstelle ist mit der Erfindung vorteilhaft nicht mehr erforderlich.

Auch kann keine Undichtigkeit zwischen Axialdichtelement und Gewindehülse entstehen, durch welche in einem eingebauten Zustand des Magnetfeldsensors beispielsweise Getriebeöl aus dem Getriebegehäuse austreten könnte. Die Gewindehülse und das Axialdichtelement sind fest und vorzugsweise unlösbar miteinander verbunden. Das Axialdichtelement kann zum Beispiel an die Gewindehülse angedreht sein, das heißt bei einer Herstellung der Gewindehülse unmittelbar mit hergestellt sein, so dass Axialdichtelement und Gewindehülse einstückig miteinander verbunden sind und nur zerstörend voneinander trennbar sind.

Bezogen auf die Sensorlängsachse des erfindungsgemäßen stabförmigen Magnetfeldsensors kragt das Axialdichtelement radial aus. In Richtung der Sensorlängsachse, das heißt in Axialrichtung des Magnetfeldsensors, ist das Axialdichtelement elastisch verformbar. Das Axialdichtelement entspricht so einem Federelement, beispielsweise kann das Axialdichtelement einer Tellerfeder entsprechen. Aufgrund der elastischen Verformbarkeit des Axialdichtelements bietet dieses die Möglichkeit, sich beim Einschrauben des Magnetfeldsensors in ein Gehäuse unter Vorspannung mit seinem Axialdichtbund von außen an die Außenwandung des Gehäuses anzulegen und so die Einschraubstelle zuverlässig abzudichten.

Zusätzliche vorteilhafte Weiterbildungen der Erfindung sind in den Unteransprüchen angegeben.

Man könnte sich vorstellen, dass das Axialdichtelement zum Beispiel als senkrechter Kreiszylinder, bei dem die Zylinderhöhe deutlich größer ist als der Zylinderradius, ausgebildet ist. Von besonderem Vorteil für einen kompakten Aufbau des Magnetfeldsensors und gute Feder- und Abdichteigenschaften des Axialdichtelements ist es hingegen, wenn gemäß einer Weiterbildung der Erfindung das Axialdichtelement eine Scheibe ist. Die Scheibe kann beispielsweise in einer Ebene senkrecht zur Sensorlängsachse angeordnet sein. Vorzugsweise ist die Scheibe eine ringförmige Scheibe, wobei die Dicke der Scheibe vorzugsweise erheblich kleiner ist als der Außenradius der Scheibe.

Gemäß einer anderen vorteilhaften Weiterbildung der Erfindung ist das Axialdichtelement eine Kegelschale, wobei die Kegelschale an ihrem dem Außengewinde der Gewindehülse zugewandten Kegelschalenende ihren größten Durchmesser aufweist. Die Kegelschale hat die Form eines Kegelmantelausschnitts eines imaginären geraden Kreiskegels. Die Kegelschale weist ein erstes Kegelschalenende auf, das der Kegelgrundfläche des imaginären Kegels zugewandt ist, und ein zweites Kegelschalenende, das der Kegelspitze des imaginären Kegels zugewandt ist, auf. Das erste Kegelschalenende, das somit einen größeren Durchmesser aufweist als das zweite Kegelschalenende, ist dem Außengewinde der Gewindehülse axial, das heißt in Richtung der Sensorlängsachse, zugewandt. Als Folge dessen liegt beim Einschrauben des Magnetfeldsensors in ein Gehäuse zunächst der ringförmige Außenrand des ersten Kegelschalenendes an der Außenwandung des Gehäuses, insbesondere Getriebegehäuses, an. Vorzugsweise ist die Kegelschale eine scheibenförmige Kegelschale, und das Axialdichtelement entspricht einer Tellerfeder.

Einer anderen vorteilhaften Weiterbildung der Erfindung gemäß ist ein erster Außendurchmesser der Gewindehülse in einem in Richtung des Außengewindes unmittelbar an das Axialdichtelement angrenzenden ersten Hülsenbereich der Gewindehülse kleiner als ein zweiter Außendurchmesser der Gewindehülse in einem in von dem Außengewinde weg weisender Richtung unmittelbar an das Axialdichtelement angrenzenden zweiten Hülsenbereich der Gewindehülse. Dadurch können in einem eingeschraubten Zustand des Magnetfeldsensors mit dem Verschrauben von Magnetfeldsensor und Gehäuse aufgebrachte sowie gegebenenfalls zusätzlich auftretende Axialkräfte vom Innenbereich, das heißt von dem der Sensorlängsachse nächstliegenden Bereich, des Axialdichtelements aufgenommen werden, und der von der Sensorlängsachse abgewandte, radial außenliegende Bereich des Axialdichtelements wird vorteilhaft nicht zusätzlich belastet. Dies hat insbesondere zur Folge, dass bei einem einer Tellerfeder entsprechenden, also kegelschalenförmigen, Axialdichtelement eine Federarbeit des Axialdichtelements weiterhin wirken kann und beispielsweise Oberflächenfehler einer Auflagefläche, insbesondere einer Außenwandung eines Getriebegehäuses, und gegebenenfalls ein Winkelfehler ausgeglichen werden können. Außerdem kann auf diese Weise das Axialdichtelement vorteilhaft auch gleichzeitig als Schraubsicherung für die Verschraubung von Magnetfeldsensor und Gehäuse dienen, da die Verschraubung fortdauernd unter mechanischer Spannung gehalten wird. Gleichzeitig besitzt der Magnetfeldsensor in seinem eingeschraubten Zustand vorteilhaft auch einen definierten Endanschlag, der zudem das Axialdichtelement selbst vor einer mechanischen Überlastung schützt.

Gemäß einer anderen vorteilhaften Weiterbildung der Erfindung weist in axial, das heißt in Richtung der Sensorlängsachse, von dem Außengewinde weg weisender Richtung unmittelbar an das Axialdichtelement angrenzend die Gewindehülse eine Umfangsnut auf. Aufgrund der Umfangsnut kann ein erheblicher Anteil von Verformungsarbeit bei einem festen Einschrauben des Magnetfeldsensors von der Gewindehülse im Bereich der Umfangsnut aufgenommen werden und wird nicht in weitere Elemente des Magnetfeldsensors eingebracht. Vorzugsweise ist der Außendurchmesser der Gewindehülse in dem Nutgrund der Umfangsnut größer als der vorgenannte erste Außendurchmesser der Gewindehülse in einem in Richtung des Außengewindes unmittelbar an das Axialdichtelement angrenzenden ersten Hülsenbereich der Gewindehülse. Beispielsweise entspricht der Außendurchmesser der Gewindehülse in dem Nutgrund der Umfangsnut dem oben genannten zweiten Außendurchmesser der Gewindehülse.

Für eine hohe Festigkeit und gute Beschichtungsfähigkeit der Gewindehülse ist es von Vorteil, wenn gemäß einer anderen Weiterbildung der Erfindung die Gewindehülse aus einer Aluminiumlegierung besteht. Die Aluminiumlegierung kann beispielsweise eine Aluminiumlegierung mit einem geringen Kupferanteil sein.

Gemäß einer vorteilhaften Weiterbildung der Erfindung weist der Axialdichtbund an seiner Oberfläche eine Eloxalschicht auf. Gegebenenfalls kann das Axialdichtelement über den Axialdichtbund hinaus gehend insgesamt an seiner Oberfläche eine Eloxalschicht aufweisen. Die Eloxalschicht, auch bezeichnet als Eloxierung oder Eloxidschicht, allgemein eine nach einem Verfahren zur anodischen Oxidation von Aluminium erzeugte Schicht, verhindert insbesondere ein Kaltverschweißen der Gewindehülse eines in ein Getriebegehäuse eingeschraubten Magnetfeldsensors mit der Außenwandung des Getriebegehäuses. Ebenso wird ein Fressen von Gewindehülse und Getriebegehäuse vermieden.

Gemäß einer anderen vorteilhaften Weiterbildung der Erfindung ist das Außengehäuse des Magnetfeldsensors ein Kunststoffspritzgussbauteil, und die Gewindehülse ist in das Kunststoffspritzgussbauteil eingespritzt. Somit ist die Gewindehülse unmittelbar in das Außengehäuse, dessen Bestandteil sie ist, eingespritzt. Hohe mechanische Belastungen, die beispielsweise bei einem Einschrauben des Magnetfeldsensors in ein Getriebegehäuse auftreten können, werden vorteilhaft von der Gewindehülse aufgefangen. Das Kunststoffspritzgussbauteil schützt in dem Magnetfeldsensor angeordnete Elemente wie zum Beispiel eine Hallsonde und einen Permanentmagneten sowie eine mit Elektronikbauteilen bestückte Leiterplatte vor möglicherweise schädigenden Umwelteinflüssen wie zum Beispiel heißem Getriebeöl. Vorzugsweise ist zumindest auch die Leiterplatte mit Elektronikbauteilen, weiter vorzugsweise auch die Hallsonde und der Permanentmagnet, in das Kunststoffspritzgussbauteil eingespritzt, so dass das Kunststoffspritzgussmaterial des Kunststoffspritzgussbauteils zumindest die Elektronikbauteile sowie gegebenenfalls Hallsonde und Permanentmagnet schützend umschließt und vor einem unberechtigten Zugriff sichert. Das Kunststoffspritzgussmaterial des Kunststoffspritzgussbauteils ist vorzugsweise ein Duroplast.

Ausführungsbeispiele der Erfindung sind in der Zeichnung dargestellt und werden im Folgenden näher beschrieben. Es zeigen:
- Figur 1: in einem Längsschnitt entlang einer Sensorlängsachse einen Magnetfeldsensor mit einer Gewindehülse,
- Figur 2: in einer perspektivischen Seitenansicht einen Ausschnitt eines anderen Magnetfeldsensors mit einer Gewindehülse,
- Figur 3: in einer Seitenansicht einen Ausschnitt des Magnetfeldsensors mit einer Gewindehülse nach Figur 2 und
- Figur 4: in einem Längsschnitt entlang Linie A-A in Figur 3 einen Ausschnitt des Magnetfeldsensors mit einer Gewindehülse nach Figur 2.

Sich jeweils entsprechende Elemente sind in allen Figuren mit gleichen Bezugszeichen versehen.

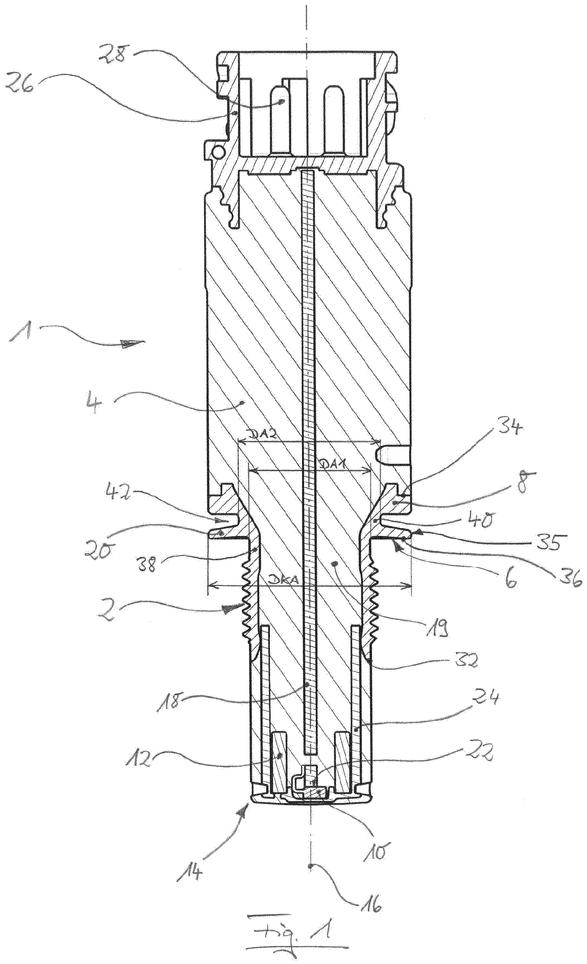

Figur 1 zeigt einen stabförmigen Magnetfeldsensor 1 mit einem ein Außengewinde 2 aufweisenden Außengehäuse 4. Das Außengehäuse 4 weist eine das Außengewinde 2 und einen Axialdichtbund 6 des Magnetfeldsensors 1 aufweisende Gewindehülse 8 auf.

Der Magnetfeldsensor 1 besitzt ferner einen eine Hallsonde 10 und einen Permanentmagneten 12 aufweisenden Sensorkopf 14. Die Hallsonde 10 ist an einer sich parallel zu einer Sensorlängsachse 16 des Magnetfeldsensors 1 erstreckenden, mit Elektronikbauteilen bestückten Leiterplatte 18 angeordnet. In diesem Ausführungsbeispiel verläuft die Sensorlängsachse 16 durch die Leiterplatte 18, die Mittelachse der Leiterplatte 18 fällt mit der Sensorlängsachse 16 zusammen.

Das Außengehäuse 4 ist ein den Sensorkopf 14 einbettendes Kunststoffspritzgussbauteil. Die Gewindehülse 8 ist in das Kunststoffspritzgussbauteil eingespritzt. Die Gewindehülse 8 dient einem Einschrauben des Magnetfeldsensors 1 in zum Beispiel ein Getriebegehäuse eines Kraftfahrzeugs, insbesondere eines Nutzfahrzeugs.

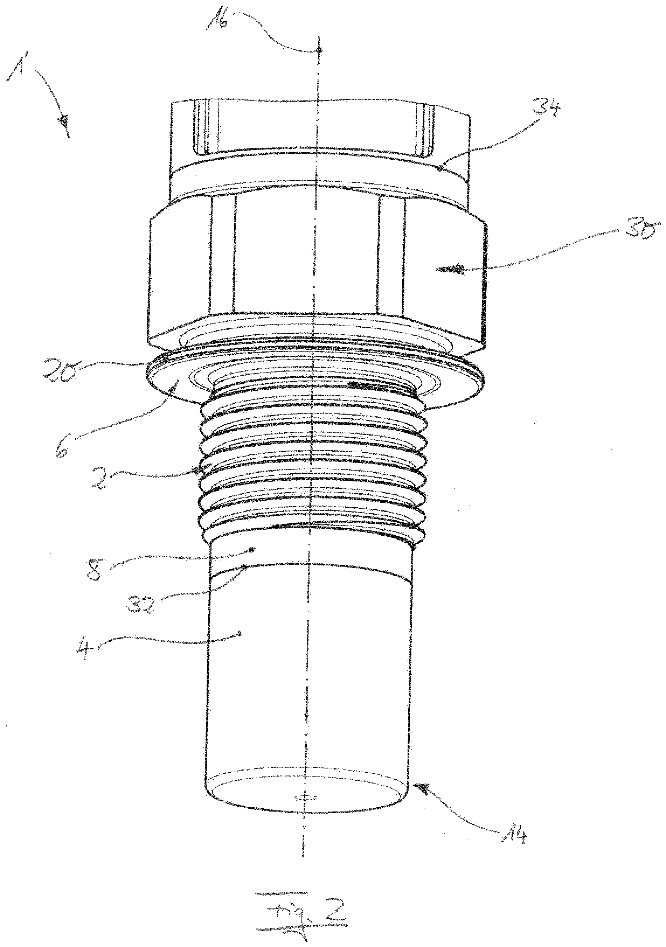

Das Kunststoffspritzgussmaterial, mithin der Kunststoff, des Kunststoffspritzgussbauteils ist in diesem und dem folgenden Ausführungsbeispiel nach Figur 2 ein Duroplast. An einem ersten Hülsenende 32 der Gewindehülse 8, in dessen Bereich das Au-ßengewinde 2 angeordnet ist, und an einem dem ersten Hülsenende 32 gegenüberliegenden zweiten Hülsenende 34 der Gewindehülse 8 grenzt die Gewindehülse 8 des Außengehäuses 4 an der Oberfläche des Magnetfeldsensors 1 jeweils an das Kunststoffspritzgussmaterial des Außengehäuses 4 an. Der Innenraum 19 der Gewindehülse 8 wird von dem Kunststoffspritzgussmaterial des Außengehäuses 4 ausgefüllt.

Die Gewindehülse 8 besteht in diesem und dem folgenden Ausführungsbeispiel aus einem Metall, und zwar vorzugsweise aus einer Aluminiumlegierung. Zumindest der Axialdichtbund 6 weist an seiner Oberfläche eine Eloxalschicht auf.

Die Gewindehülse 8 des Außengehäuses 4 des Magnetfeldsensors 1 weist ein bezogen auf die Sensorlängsachse 16 radial auskragendes Axialdichtelement 20 auf. Das Axialdichtelement 20 ist in Axialrichtung, das heißt in einer Richtung parallel zu der Sensorlängsachse 16, elastisch verformbar und ein einziges Bauteil bildend mit der Gewindehülse 8 verbunden. An seiner in Axialrichtung dem Außengewinde 2 der Gewindehülse 8 zugewandten Außenseite bildet das Axialdichtelement 20 den Axialdichtbund 6.

Die Hallsonde 10 ist an einer ersten Stirnseite 22 der Leiterplatte 18 angeordnet. Der Sensorkopf 14 weist eine die Hallsonde 10 und den Permanentmagneten 12, der hier als Ringmagnet ausgebildet ist, zueinander festlegende Positionierhülse 24 auf. Weiterhin positioniert die Positionierhülse 24 die Hallsonde 10 und den Permanentmagneten 12 zu der Leiterplatte 18. Die Leiterplatte 18 ist in das Außengehäuse 4, das heißt in das Kunststoffspritzgussbauteil, eingespritzt. Ebenso sind die Hallsonde 10 und der Permanentmagnet 12 in das Außengehäuse 4 eingespritzt. Gleiches gilt für die Positionierhülse 24.

An einem dem an einem ersten Ende des stabförmigen Magnetfeldsensors 1 angeordneten Sensorkopf 14 gegenüberliegenden zweiten Ende des Magnetfeldsensors 1 befindet sich ein Steckersockel 26 mit Anschlusskontakten 28 zur Verbindung des Magnetfeldsensors 1 mit zum Beispiel einem Fahrtenschreiber des Kraftfahrzeugs.

Im Inneren des Magnetfeldsensors 1 sind die Anschlusskontakte 28 mit der Leiterplatte 18 elektrisch kontaktiert. Der Steckersockel 26 ist in das Außengehäuse 4 eingespritzt. Zwischen dem an dem zweiten Ende des Magnetfeldsensors 1 angeordneten Steckersockel 26 und dem an dem ersten Ende des Magnetfeldsensors 1 angeordneten Sensorkopf 14 befindet sich die in das Außengehäuse 4 eingespritzte Gewindehülse 8 mit dem Axialdichtelement 20 und dem Axialdichtbund 6. Steckersockel 26, Gewindehülse 8 und Sensorkopf 14 sind jeweils symmetrisch zur Sensorlängsachse 16 angeordnet, so dass sich Steckersockel 26, Gewindehülse 8 und Sensorkopf 14 in einer linearen Anordnung zueinander befinden.

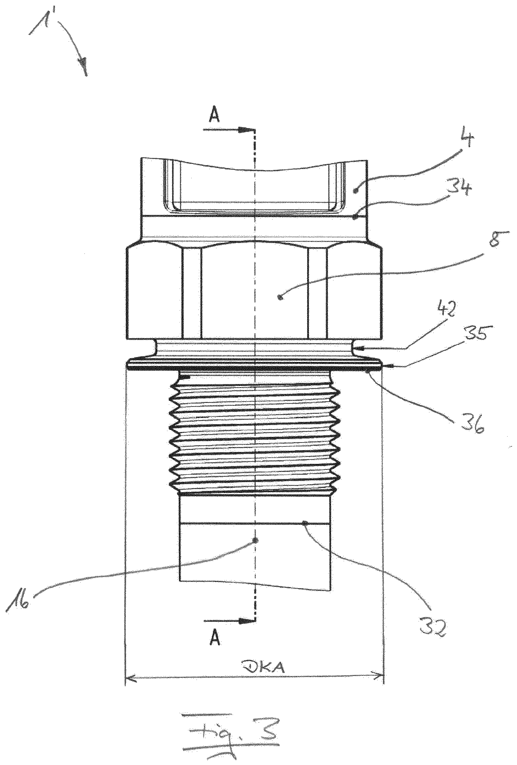

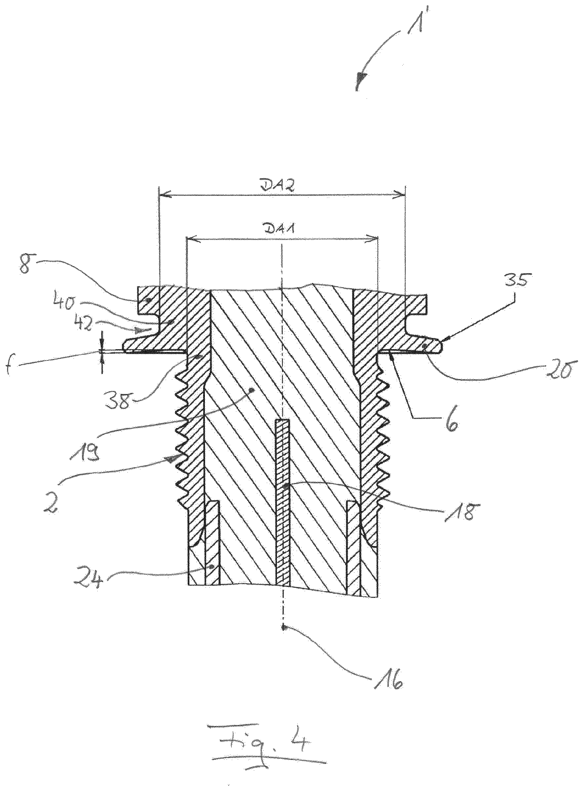

Ausschnitte eines dem in Figur 1 gezeigten stabförmigen Magnetfeldsensor 1 ähnlichen stabförmigen Magnetfeldsensors 1' zeigen Figur 2 in einer perspektivischen Seitenansicht sowie Figur 3 in einer Seitenansicht und Figur 4 in einer Schnittansicht entlang Linie A-A in Figur 3. Der Magnetfeldsensor 1' nach Figuren 2 bis 4 weist entsprechend dem ersten Ausführungsbeispiel nach Figur 1 ein Außengehäuse 4, das ein Kunststoffspritzgussbauteil ist, in welches Kunststoffspritzgussbauteil eine ein Außengewinde 2 und einen Axialdichtbund 6 aufweisende Gewindehülse 8 eingespritzt ist, und einen Sensorkopf 14 auf. Der Sensorkopf 14 ist entsprechend dem Sensorkopf nach Figur 1 aufgebaut. Nicht dargestellt ist in Figuren 2 bis 4 ein Steckersockel mit Anschlusskontakten zur Verbindung des Magnetfeldsensors 1' beispielsweise mit einem Fahrtenschreiber eines Kraftfahrzeugs, insbesondere eines Nutzfahrzeugs.

Die Gewindehülse 8 weist ein radial auskragendes, in Axialrichtung elastisch verformbares Axialdichtelement 20 auf, das ein einziges Bauteil bildend mit der Gewindehülse 8 verbunden ist. An seiner in Axialrichtung dem Außengewinde 2 der Gewindehülse 8 zugewandten Außenseite bildet das Axialdichtelement 20 den Axialdichtbund 6.

Weiterhin weist die Gewindehülse 8 einen Außen-Sechskant 30 zum Ansatz eines Schraubenschlüssels zu einem Einschrauben des Magnetfeldsensors 1' in beispielsweise ein Getriebegehäuse eines Kraftfahrzeugs, insbesondere Nutzfahrzeugs, auf. Das Außengewinde 2 ist im Bereich eines ersten Hülsenendes 32 der Gewindehülse 8 und der Außen-Sechskant 30 im Bereich eines zweiten Hülsenendes 34 der Gewindehülse 8 angeordnet.

An ihrem ersten Hülsenende 32 und ihrem zweiten Hülsenende 34 grenzt die Gewindehülse des Außengehäuses 4 an der Oberfläche des Magnetfeldsensors 1' jeweils an das Kunststoffspritzgussmaterial des Außengehäuses 4 an. Der Innenraum 19 (siehe Figur 4) der Gewindehülse 8 wird von dem Kunststoffspritzgussmaterial des Außengehäuses 4 ausgefüllt. In Axialrichtung zwischen Außengewinde 2 und Außen-Sechskant 30 befindet sich das Axialdichtelement 20.

Es ist zu erkennen, dass das Axialdichtelement 20 sowohl in dem Ausführungsbeispiel nach Figur 1 als auch in dem Ausführungsbeispiel nach Figuren 2 bis 4 scheibenförmig ausgebildet ist. Das Axialdichtelement 20 weist jeweils die Form einer kegelförmig geformten Ringscheibe 35 auf und entspricht damit einer Tellerfeder. Das Axialdichtelement 20 ist demgemäß jeweils eine Kegelschale, speziell eine kegelige Ringschale.

Die Kegelschale weist an ihrem dem Außengewinde 2 der Gewindehülse 8 zugewandten Kegelschalenende 36 ihren größten Durchmesser DKA auf (siehe Figuren 1, 3). Dieser größte Durchmesser DKA ist der Außendurchmesser der Kegelschale und somit auch des Axialdichtelements 20. Das Axialdichtelement 20 weist in Axialrichtung einen Federweg f (siehe Figur 4) auf, um den es in Axialrichtung elastisch verformbar ist.

In Figuren 1, 4 ist erkennbar, dass ein erster Außendurchmesser DA1 der Gewindehülse 8 in einem in Richtung des Außengewindes 2 unmittelbar an das Axialdichtelement 20 angrenzenden ersten Hülsenbereich 38 der Gewindehülse 8 kleiner ist als ein zweiter Außendurchmesser DA2 der Gewindehülse 8 in einem in von dem Außengewinde 2 weg weisender Richtung unmittelbar an das Axialdichtelement 20 angrenzenden zweiten Hülsenbereich 40 der Gewindehülse 8. Außerdem weist in axial von dem Außengewinde 2 weg weisender Richtung unmittelbar an das Axialdichtelement 20 angrenzend die Gewindehülse 8 eine Umfangsnut 42 auf.

Die Umfangsnut 42 kann allgemein eine umlaufende Aussparung sein. Vorzugsweise ist der Kerndurchmesser der umlaufenden Aussparung größer als der Gewindeaußendurchmesser des Außengewindes 2. Der Kerndurchmesser der Aussparung ist im Falle der Umfangsnut 42 der Durchmesser der Gewindehülse 8 im Bereich des Nutgrundes der Umfangsnut 42. Dieser Durchmesser entspricht in den hier gezeigten Ausführungsbeispielen dem oben beschriebenen zweiten Außendurchmesser DA2 der Gewindehülse 8.

Wie in Figur 4 zu erkennen, ist der zweite Außendurchmesser DA2 der Gewindehülse 8 größer als der Gewindedurchmesser, insbesondere der Gewindeaußendurchmesser, des Außengewindes 2. Dadurch entsteht in einem eingeschraubten Zustand des Magnetfeldsensors 1', das heißt wenn der Magnetfeldsensor 1' beispielsweise in ein Getriebegehäuse eines Kraftfahrzeugs eingeschraubt ist, ein fester Anschlag, und das Axialdichtelement 20, das hier einer Tellerfeder entspricht, wird nicht überlastet.

Eine ähnliche Ausführung zeigt auch Figur 1, wobei bei diesem Ausführungsbeispiel die Differenz zwischen dem zweiten Außendurchmesser DA2 der Gewindehülse 8 und dem Gewindedurchmesser, insbesondere Gewindeaußendurchmesser, des Außengewindes 2 geringer ist als bei dem Ausführungsbeispiel nach Figur 4.

## Patentansprüche

1. Stabförmiger Magnetfeldsensor (1; 1') mit einem ein Außengewinde (2) und einen Axialdichtbund (6) des Magnetfeldsensors (1; 1') aufweisenden Außengehäuse (4), wobei das Außengehäuse (4) eine das Außengewinde (2) und den Axialdichtbund (6) aufweisende Gewindehülse (8) aufweist, **dadurch gekennzeichnet, dass** die Gewindehülse (8) ein radial auskragendes, in Axialrichtung elastisch verformbares Axialdichtelement (20) aufweist, wobei das Axialdichtelement (20) ein einziges Bauteil bildend mit der Gewindehülse (8) verbunden ist und an seiner in Axialrichtung dem Außengewinde (2) der Gewindehülse (8) zugewandten Außenseite den Axialdichtbund (6) bildet, dass ein erster Außendurchmesser (DA1) der Gewindehülse (8) in einem in Richtung des Außengewindes (2) unmittelbar an das Axialdichtelement (20) angrenzenden ersten Hülsenbereich (38) der Gewindehülse (8) kleiner ist als ein zweiter Außendurchmesser (DA2) der Gewindehülse (8) in einem in von dem Außengewinde (2) weg weisender Richtung unmittelbar an das Axialdichtelement (20) angrenzenden zweiten Hülsenbereich (40) der Gewindehülse (8) und dass in axial von dem Außengewinde (2) weg weisender Richtung unmittelbar an das Axialdichtelement (20) angrenzend die Gewindehülse (8) eine Umfangsnut (42) aufweist.

2. Magnetfeldsensor nach Anspruch 1, **dadurh gekennzeichnet,** dass das Axialdichtelement (20) eine Scheibe ist.

3. Magnetfeldsensor nach Anspruch 1 oder 2, **dadurch gekennzeichnet, dass** das Axialdichtelement (20) eine Kegelschale ist, wobei die Kegelschale an ihrem dem Außengewinde (2) der Gewindehülse (8) zugewandten Kegelschalenende (36) ihren größten Durchmesser (DKA) aufweist.

4. Magnetfeldsensor nach einem der vorhergehenden Ansprüche, **dadurch gekennzeichnet, dass** die Gewindehülse (8) aus einer Aluminiumlegierung besteht.

5. Magnetfeldsensor nach Anspruch 4, **dadurch gekennzeichnet, dass** der Axialdichtbund (6) an seiner Oberfläche eine Eloxalschicht aufweist.

6. Magnetfeldsensor nach einem der vorhergehenden Ansprüche, **dadurch gekennzeichnet, dass** das Außengehäuse (4) des Magnetfeldsensors (1; 1') ein Kunststoffspritzgussbauteil ist und dass die Gewindehülse (8) in das Kunststoffspritzgussbauteil eingespritzt ist.

## Claims

1. Rod-shaped magnetic field sensor (1; 1') comprising an outer housing (4) having an external thread (2) and an axial sealing collar (6) of the magnetic field sensor (1; 1'), the outer housing (4) having a threaded sleeve (8) having the external thread (2) and the axial sealing collar (6), **characterized in that** the threaded sleeve (8) has a radially projecting axial sealing element (20) that can be deformed elastically in the axial direction, the axial sealing element (20), forming a single component, is connected to the threaded sleeve (8) and forms the axial sealing collar (6) on its outer side facing the external thread (2) of the threaded sleeve (8) in the axial direction, **in that** a first external diameter (DA1) of the threaded sleeve (8) is smaller in a first sleeve region (38) of the threaded sleeve (8), directly adjoining the axial sealing element (20) in the direction of the external thread (2), than a second external diameter (DA2) of the threaded sleeve (8) in a second sleeve region (40) of the threaded sleeve (8) directly adjoining the axial sealing element (20) in a direction pointing away from the external thread (2), and **in that** the threaded sleeve (8) has a circumferential groove (42) in the direction pointing axially away from the external thread (2), directly adjacent to the axial sealing element (20).

2. Magnetic field sensor according to Claim 1, **characterized in that** the axial sealing element (20) is a washer.

3. Magnetic field sensor according to Claim 1 or 2, **characterized in that** the axial sealing element (20) is a conical shell, wherein the conical shell has its greatest diameter (DKA) at its conical shell end (36) facing the external thread (2) of the threaded sleeve (8).

4. Magnetic field sensor according to one of the preceding claims, **characterized in that** the threaded sleeve (8) consists of an aluminium alloy.

5. Magnetic field sensor according to Claim 4, **characterized in that** the axial sealing collar (6) has an anodised layer on its surface.

6. Magnetic field sensor according to one of the preceding claims, **characterized in that** the external thread (4) of the magnetic field sensor (1; 1') is an injection-moulded plastic component, and **in that** the threaded sleeve (8) is injection-moulded into the injection-moulded plastic component.

## Revendications

1. Capteur de champ magnétique en forme de tige (1; 1') avec un boîtier extérieur (4) présentant un filet extérieur (2) et un épaulement d'étanchéité axiale (6) du capteur de champ magnétique (1; 1'), dans lequel le boîtier extérieur (4) présente une douille filetée (8) présentant le filet extérieur (2) et l'épaulement d'étanchéité axiale (6), **caractérisé en ce que** la douille filetée (8) présente un élément d'étanchéité axiale (20) saillant radialement et élastiquement déformable, dans lequel l'élément d'étanchéité axiale (20) est assemblé à la douille filetée (8) en formant une seule pièce et forme l'épaulement d'étanchéité axiale (6) sur son côté extérieur tourné en direction axiale vers le filet extérieur (2) de la douille filetée (8), **en ce qu'**un premier diamètre extérieur (DA1) de la douille filetée (8) dans une première région de douille (38) de la douille filetée (8) directement adjacente à l'élément d'étanchéité axiale (20) en direction du filet extérieur (2) est plus petit qu'un deuxième diamètre extérieur (DA2) de la douille filetée (8) dans une deuxième région de douille (40) de la douille filetée (8) directement adjacente à l'élément d'étanchéité axiale (20) dans la direction opposée au filet extérieur (2) et **en ce que** la douille filetée (8) présente une rainure périphérique (42) directement adjacente à l'élément d'étanchéité axiale (20) dans la direction opposée au filet extérieur (2).

2. Capteur de champ magnétique selon la revendication 1, **caractérisé en ce que** l'élément d'étanchéité axiale (20) est un disque.

3. Capteur de champ magnétique selon la revendication 1 ou 2, **caractérisé en ce que** l'élément d'étanchéité axiale (20) est une coquille conique, dans lequel la coquille conique présente son plus grand diamètre (DKA) à son extrémité de coquille conique (36) tournée vers le filet extérieur (2) de la douille filetée (8).

4. Capteur de champ magnétique selon l'une quelconque des revendications précédentes, **caractérisé en ce que** la douille filetée (8) est constituée d'un alliage d'aluminium.

5. Capteur de champ magnétique selon la revendication 4, **caractérisé en ce que** l'épaulement d'étanchéité axiale (6) présente à sa surface une couche anodisée.

6. Capteur de champ magnétique selon l'une quelconque des revendications précédentes, **caractérisé en ce que** le boîtier extérieur (4) du capteur de champ magnétique (1; 1') est une pièce moulée par injection en matière plastique et **en ce que** la douille filetée (8) est injectée dans la pièce moulée par injection en matière plastique.
